(19) Europäisches Patentamt
European Patent Office
Office européen des brevets

(11) **EP 2 171 488 B1**

(12) **EUROPÄISCHE PATENTSCHRIFT**

(45) Veröffentlichungstag und Bekanntmachung des Hinweises auf die Patenterteilung:
**24.11.2010 Patentblatt 2010/47**

(21) Anmeldenummer: **07786413.0**

(22) Anmeldetag: **24.07.2007**

(51) Int Cl.:
**G01R 31/08** (2006.01)  **H02H 7/26** (2006.01)

(86) Internationale Anmeldenummer:
**PCT/EP2007/006703**

(87) Internationale Veröffentlichungsnummer:
**WO 2009/012799 (29.01.2009 Gazette 2009/05)**

(54) **VERFAHREN ZUM ORTEN EINES ERDFEHLERS NACH DEM DISTANZSCHUTZPRINZIP UND ELEKTRISCHES DISTANZSCHUTZGERÄT**

METHOD FOR LOCATING A GROUND FAULT ACCORDING TO THE DISTANCE PROTECTION PRINCIPLE AND ELECTRIC DISTANCE PROTECTION DEVICE

PROCÉDÉ DE LOCALISATION D'UN DÉFAUT À LA TERRE SELON LE PRINCIPE DE LA PROTECTION DE DISTANCE ET APPAREIL DE PROTECTION DE DISTANCE ÉLECTRIQUE

(84) Benannte Vertragsstaaten:
**AT BE BG CH CY CZ DE DK EE ES FI FR GB GR HU IE IS IT LI LT LU LV MC MT NL PL PT RO SE SI SK TR**

(43) Veröffentlichungstag der Anmeldung:
**07.04.2010 Patentblatt 2010/14**

(73) Patentinhaber: **Siemens Aktiengesellschaft 80333 München (DE)**

(72) Erfinder:
• **ERKENS, Ingo**
  **90518 Altdorf-Röthenbach (DE)**
• **PEUKERT, David**
  **10557 Berlin (DE)**

(56) Entgegenhaltungen:
**EP-A- 1 739 441**

**Beschreibung**

Die Erfindung betrifft ein Verfahren zum Orten eines Erdfehlers auf einem Abschnitt einer elektrischen Energieversorgungsleitung nach dem Distanzschutzprinzip, wobei beim Auftreten eines Erdfehlers auf dem Abschnitt ein den in dem Abschnitt fließenden Strom angebender Strommesswert erfasst wird, ein die an dem Abschnitt anliegende Spannung angebender Spannungsmesswert erfasst wird sowie ein den entlang des Abschnitts fließenden Erdstrom angebender Erdstrommesswert erfasst wird und mit den erfassten Messwerten ein Fehlerortwert berechnet wird, der den Ort des Erdfehlers auf dem Abschnitt angibt, wobei dieser Fehlerortwert unter Verwendung der Leitungsimpedanz des Abschnitts und der Erdimpedanz des entlang des Abschnitts verlaufenden Erdreiches gebildet wird.

Die Erfindung betrifft auch ein elektrisches Distanzschutzgerät zur Erfassung und Ortung von Erdfehlern auf einen Abschnitt einer elektrischen Energieübertragungsleitung mit einer Messwerterfassungseinrichtung zum Erfassen von Strom- und Spannungsmesswerten sowie Erdstrommesswerten, die Werte des in dem Abschnitt fließenden Stromes und der an diesem anliegenden Spannung sowie des entlang des Abschnitts fließenden Erdstromes angeben, und einer Datenverarbeitungseinrichtung, die mit den erfassten Messwerten einen Fehlerortwert berechnet, der den Ort des Erdfehlers auf dem Abschnitt angibt, wobei dieser Fehlerortwert unter Verwendung der Leitungsimpedanz des Abschnitts und der Erdimpedanz des entlang des Abschnitts verlaufenden Erdreiches gebildet wird.

Zur Überwachung und zum Schutz elektrischer Energieversorgungsnetze werden üblicherweise sogenannte elektrische Schutzgeräte verwendet. Ein elektrisches Schutzgerät nimmt an einer Messstelle des elektrischen Energieversorgungsnetzes Messwerte auf, die einen Betriebszustand des elektrischen Energieversorgungsnetzes charakterisieren. Hierbei kann es sich beispielsweise um Strom- und Spannungsmesswerte handeln. Anhand dieser Messwerte und unter Verwendung spezieller Schutzalgorithmen trifft das Schutzgerät eine Entscheidung darüber, ob sich der von ihm überwachte Teil des elektrischen Energieversorgungsnetzes in einem zulässigen oder einem unzulässigen Betriebszustand befindet. Ein unzulässiger Betriebszustand liegt beispielsweise dann vor, wenn in dem überwachten Teil des elektrischen Energieversorgungsnetzes ein Kurzschluss aufgetreten ist. Liegt ein unzulässiger Betriebszustand vor, dann gibt das Schutzgerät üblicherweise automatisch einen sogenannten "Trip-Befehl" an einen ihm zugeordneten Leistungsschalter ab, der als Reaktion auf den Trip-Befehl seine Schaltkontakte öffnet und damit den fehlerbehafteten Abschnitt vom restlichen Energieversorgungsnetz abtrennt.

Ein häufig eingesetztes elektrisches Schutzgerät ist beispielsweise ein sogenanntes Distanzschutzgerät. Ein Verfahren bzw. Distanzschutzgerät der eingangs genannten Art ist beispielsweise aus dem Fachbuch "Digitaler Distanzschutz: Grundlagen und Anwendung", Gerhard Ziegler, 1999, herausgegeben von der Siemens Aktiengesellschaft, bekannt, wobei insbesondere auf Kapitel 3.2 "Numerische Distanzmessung" verwiesen wird. Ein Distanzschutzgerät misst an einer Messstelle einer elektrischen Energieversorgungsleitung auftretende Ströme und Spannungen und berechnet daraus einen Impedanzwert der elektrischen Energieversorgungsleitung. Anhand des berechneten Impedanzwertes kann beispielsweise unter Zuhilfenahme bestimmter Auslösekennlinien überprüft werden, ob ein Fehler, wie z.B. ein Kurzschluss, auf der elektrischen Energieversorgungsleitung aufgetreten ist. Liegt ein Fehler vor, so gibt das Distanzschutzgerät einen Trip-Befehl an einen ihm zugeordneten Leistungsschalter ab, der daraufhin den fehlerbehafteten Abschnitt der elektrischen Energieversorgungsleitung von dem übrigen Energieversorgungsnetz abtrennt. Zusätzlich gibt ein Distanzschutzgerät auch den Ort des auf der überwachten Energieübertragungsleitung aufgetretenen Fehlers an. Distanzschutzgeräte werden häufig zur Überwachung von elektrischen Energieversorgungsleitungen eingesetzt, weil sie eine hohe Selektivität aufweisen und in der Lage sind, autonome Entscheidungen zu treffen, ohne dass hierzu eine Kommunikation mit einem anderen Schutzgerät notwendig ist.

Kurzschlüsse können beispielsweise zwischen zwei oder drei Phasen der Energieübertragungsleitung (ein sogenannter "Leiter-Leiter-Kurzschluss") oder zwischen einer jeweiligen Phase und der elektrischen Erde (ein sogenannter "Leiter-Erde-Kurzschluss") auftreten. Im Falle eines Leiter-Leiter-Kurzschlusses zwischen zwei oder drei Phasen der elektrischen Energieversorgungsleitung kann die Erkennung und Ortung des Kurzschlusses sehr leicht erfolgen, da die zur Bestimmung eines Impedanzschwellenwertes benötigten Leistungsimpedanzen der von dem Fehler betroffenen Leitungen üblicherweise bekannt sind.

Wesentlich häufiger als Leiter-Leiter-Kurzschlüsse treten jedoch Leiter-Erde-Kurzschlüsse auf, wobei es sich im Wesentlichen um einphasige Kurzschlüsse mit Erdbeteiligung handelt. Zur Ortung solcher Leiter-Erde-Kurzschlüsse ist die Kenntnis der Erdimpedanz des Erdreiches entlang des überwachten Abschnitts der Energieübertragungsleitung notwendig, da dieses an der Impedanz der von dem Distanzschutzgerät gemessenen Leiter-Erde-Schleife maßgeblich beteiligt ist.

Der für die Erdimpedanz verwendete Einstellwert, der als Parameter in dem elektrischen Distanzschutzgerät eingestellt werden muss, wird bisher üblicherweise als fester Einstellwert des Distanzschutzgerätes vorgegeben. Der Wert kann hierbei entweder aus Parametern der elektrischen Energieversorgungsleitung, wie beispielsweise der Nullsystemimpedanz und der Mitsystemimpedanz der elektrischen Energieversorgungsleitung, abgeleitet oder aber explizit gemessen werden.

Der Erfindung liegt die Aufgabe zugrunde, ein Verfahren bzw. ein Distanzschutzgerät der oben genannten Art anzugeben, das eine genauere Ortung eines aufgetretenen Erdfehlers ermöglicht.

Patentschrift EP 17 394 41 A1 (ABBOY) offenbart ein System zur Ortung von Leiter-Erde-Kutzchlüssen.

Hinsichtlich des Verfahrens wird diese Aufgabe durch ein gattungsgemäßes Verfahren gelöst, bei dem der Wert der zur Bildung des Fehlerortwertes verwendeten Erdimpedanz in Abhängigkeit zumindest eines Umgebungsparameters, der Umwelteinflüsse auf das betroffene Erdreich beschreibt, dynamisch festgelegt wird. Durch die dynamische Festlegung des Wertes der verwendeten Erdimpedanz kann der Fehlerortwert wesentlich genauer bestimmt werden, da die Erdimpedanz kontinuierlich an die tatsächlichen durch Umwelteinflüsse hervorgerufenen Veränderungen angepasst wird.

Konkret kann gemäß einer vorteilhaften Ausführungsform des erfindungsgemäßen Verfahrens vorgesehen sein, dass als Umgebungsparameter zumindest ein Parameter aus folgender Auflistung verwendet wird: eine Luftfeuchtigkeit, eine Feuchtigkeit des betroffenen Erdreiches, eine Lufttemperatur, eine Temperatur des betroffenen Erdreiches. Diese Parameter stellen nämlich die Haupteinflussfaktoren dar, die umweltbedingte Veränderungen der Erdimpedanz des Erdreiches hervorrufen. Eine weitere vorteilhafte Ausführungsform des erfindungsgemäßen Verfahrens sieht außerdem vor, dass der zumindest eine verwendete Umgebungsparameter kontinuierlich gemessen wird. Auf diese Weise kann der Wert für die Erdimpedanz kontinuierlich den entsprechenden Umweltbedingungen angepasst werden.

Alternativ hierzu kann auch vorgesehen sein, dass der zumindest eine verwendete Umgebungsparameter aus einer elektronischen Tabelle in Abhängigkeit der aktuellen Jahres- und/oder Tageszeit ausgelesen wird. In diesem Fall werden die Umgebungsparameter nicht explizit gemessen, sondern beispielsweise aus einer Klimatabelle ausgelesen, die übliche Umgebungsparameter für die jeweils aktuelle Jahres- oder Tageszeit angibt.

Wenn die Abhängigkeit der Erdimpedanz von dem zumindest einen betrachteten Umgebungsparameter bereits vorab bekannt ist, kann diese als mathematische Funktion zur Durchführung des erfindungsgemäßen Verfahrens bereits vorab bereitgestellt werden. Da häufig eine Abhängigkeit der Erdimpedanz von dem zumindest einen Umgebungsparameter jedoch nicht bekannt sein wird, wird gemäß einer weiteren vorteilhafte Ausführungsform des erfindungsgemäßen Verfahrens vorgeschlagen, dass während einer Lernphase der zu dem zumindest einen verwendeten Umgebungsparameter gehörende Wert der Erdimpedanz gemessen wird, eine Abhängigkeit des Wertes der Erdimpedanz von dem zumindest einen verwendeten Umgebungsparameter in Form einer mathematischen Funktion bestimmt wird und im Anschluss an die Lernphase der Wert der Erdimpedanz unter Anwendung dieser mathematischen Funktion bestimmt wird. Hierdurch wird sozusagen ein selbst lernendes Distanzschutzverfahren zur Fehlerortung angegeben, separate Messungen zur Ermittlung der mathematischen Funktion müssen nicht mehr durchgeführt werden.

Der Wert der Erdimpedanz kann in diesem Zusammenhang beispielsweise von zwei miteinander über eine Kommunikationsverbindung gekoppelten Distanzschutzgeräten entsprechend dem von der Anmelderin in der internationalen Patentanmeldung PCT/DE2007/000870 beschriebenen Verfahren ermittelt wird.

Um die verwendete mathematische Funktion zur Beschreibung der Abhängigkeit des Erdimpedanz von dem zumindest einen verwendeten Umgebungsparameter ständig zu verfeinern, kann außerdem vorgesehen sein, dass die Lernphase und die Bestimmung der mathematischen Funktion wiederholt durchgeführt werden. Hierbei können Lernphasen beispielsweise in regelmäßigen Abständen durchgeführt oder durch äußere Ereignisse - wie beispielsweise starke Regenfälle mit damit verbundener starker Durchfeuchtung des verbundenen Erdreiches - angestoßen werden.

Schließlich ist gemäß einer weiteren vorteilhaften Ausführungsform des erfindungsgemäßen Verfahrens vorgesehen, dass bei einer mehrphasigen elektrischen Energieübertragungsleitung das Verfahren für jede Phase der Energieübertragungsleitung durchgeführt wird.

Hinsichtlich des elektrischen Distanzschutzgerätes wird die oben genannte Aufgabe durch ein Distanzschutzgerät der eingangs genannten Art gelöst, bei dem die Datenverarbeitungseinrichtung zur Durchführung eines Verfahrens gemäß einer der vorangehend beschriebenen Ausführungsformen eingerichtet ist.

Die Erfindung wird im Folgenden anhand von Ausführungsbeispielen näher dargestellt. Hierzu zeigen

Figur 1     eine schematische Darstellung eines Distanzschutzgerätes an einer dreiphasigen Energie- übertragungsleitung,

Figur 2     eine schematische Darstellung eines Distanzschutzgerätes gemäß einer ersten Ausfüh- rungsform und

Figur 3     eine schematische Darstellung eines Distanzschutzgerätes gemäß einer zweiten Ausfüh- rungsform.

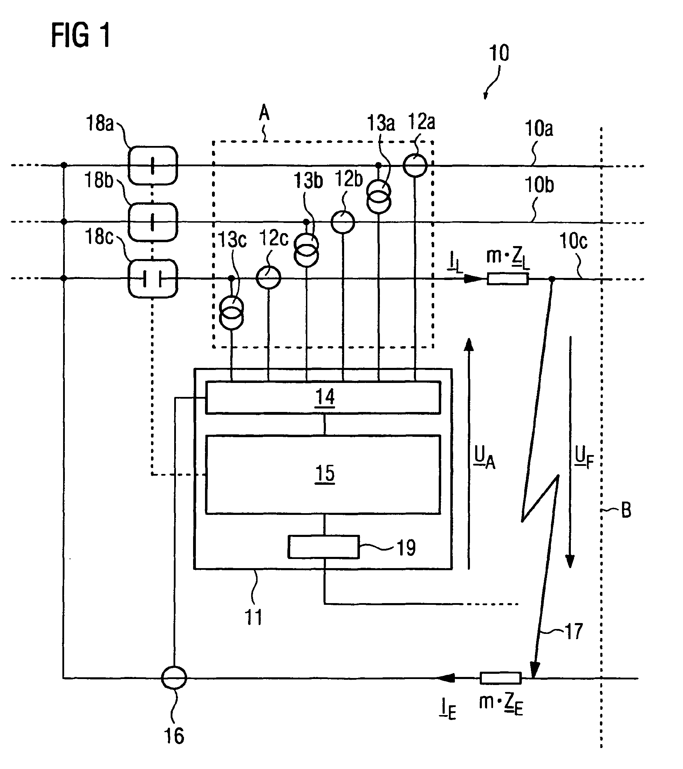

Figur 1 zeigt einen Abschnitt 10 einer im Weiteren nicht näher dargestellten geerdeten dreiphasigen elektrischen Energieübertragungsleitung. Der Abschnitt 10 ist auf seiner einen Seite durch eine Messstelle A eines Distanzschutzgerätes 11 begrenzt. Auf seiner anderen Seite wird der Abschnitt 10 durch eine gestrichelte Linie B begrenzt, die beispielsweise eine Messstelle eines weiteren Distanzschutzgerätes, das in Figur 1 nicht näher dargestellt ist, kennzeichnet. Der durch die Messstelle A und die gestrichelte Linie B begrenzte Abschnitt 10 der dreiphasigen elektrischen Energieübertragungsleitung wird von dem elektrischen Distanzschutzgerät 11 auf unzulässige Betriebszustände, wie beispielsweise Kurzschlüsse, überwacht. Hierzu werden an den jeweiligen Phasen 10a, 10b und 10c des Abschnitts 10 mittels lediglich schematisch dargestellter Stromwandler 12a, 12b und 12c sowie Spannungswandler 13a, 13b und 13c Strom- und Spannungsmesswerte der elektrischen Energieübertragungsleitung aufgenommen und einer Messwerterfassungseinrichtung 14 des Distanzschutzgerätes 11 zugeführt. Außerdem wird der Messwerterfassungseinrichtung 14 ein mit einem weiteren (ebenfalls an Messstelle A angeordneten) Stromwandler 16 erfasster Erdstrommesswert zugeführt.

In der Messwerterfassungseinrichtung 14 findet üblicherweise eine Transformierung von den immer noch vergleichsweise hohen Strom- bzw. Spannungsniveaus der ausgangsseitig von den Stromwandlern 12a, 12b und 12c sowie 16 bzw. Spannungswandlern 13a, 13b und 13c abgegebenen Ströme bzw. Spannungen auf von dem Distanzschutzgerät 11 verarbeitbare Strom- bzw. Spannungsniveaus statt. Außerdem finden in der Messwerterfassungseinrichtung üblicherweise eine Analog-Digital-Wandlung und ggf. weitere Vorverarbeitungsschritte, wie z. B. eine Filterung der empfangenen Messwerte, statt. Sollen die Messwerte in Form von Strom- bzw. Spannungszeigern weiter verarbeitet werden, so findet in der Messwerterfassungseinrichtung üblicherweise auch eine Strom- bzw. Spannungszeigerbildung statt, so dass die gebildeten Strom- bzw. Spannungszeiger dann über Informationen hinsichtlich Amplitude und Phasenlage von Strom und Spannung der einzelnen Phasen 10a, 10b und 10c des Abschnitts 10 der elektrischen Energieübertragungsleitung bzw. des Erdstromes verfügen.

Die mit der Messwerterfassungseinrichtung 14 erfassten und ggf. vorverarbeiteten Messwerte von Strom und Spannung werden dann einer Datenverarbeitungseinrichtung 15 des Distanzschutzgerätes 11 zugeführt. Die Datenverarbeitungseinrichtung bestimmt anhand dem Fachmann hinlänglich bekannter Algorithmen, ob ein Fehler auf dem Abschnitt 10 der elektrischen Energieübertragungsleitung vorliegt und erkennt außerdem die fehlerbehaftete Schleife (z.B. eine Leiter-Leiter-Schleife zwischen Phasen 10a und 10b oder eine Leiter-Erde-Schleife zwischen Phase 10c und Erde). Wenn die Datenverarbeitungseinrichtung einen solchen Fehler erkennt, gibt sie entsprechende TRIP-Signale an den einzelnen Phasen 10a, 10b, 10c zugeordnete Leistungsschalter 18a, 18b, 18c ab, um die von dem Fehler betroffene (n) Phase(n) von der übrigen Energieversorgungsleitung abzutrennen.

Im Anschluss daran berechnet die Datenverarbeitungseinrichtung anhand der gemessenen Strom, Erdstrom- und Spannungsmesswerte einen Fehlerortwert, der den Ort des Fehlers auf dem Abschnitt 10 (meistens relativ zur Leitungslänge des Abschnitts 10) angibt. Hierzu werden die Leiterimpedanzen der jeweiligen Phasen und - bei Erdfehlern -die Erdimpedanz des entlang des Abschnittes verlaufenden Erdreiches benötigt. Im folgenden soll näher auf die Ortung eines Erdfehlers eingegangen werden.

Gemäß Figur 1 sei angenommen, dass ein Kurzschluss 17 zwischen der Phase 10c und Erde aufgetreten ist. Hierdurch wird eine sogenannte Leiter-Erde-Schleife zwischen der Phase 10c (dem Leiter) und der Erde erzeugt, die von der Messstelle A über die Phase 10c bis zur Stelle des Kurzschlusses 17 und von dort wieder zurück über die Erde zur Messstelle A bzw. dem Einbauort des Stromwandlers 16 verläuft.

Für die weitere Erläuterung soll zunächst anhand von Figur 1 die Berechnung eines Fehlerortwertes m durch die Datenverarbeitungseinrichtung 15 des Distanzschutzgerätes 11 hergeleitet werden. Dieser Fehlerortwert m gibt - bezogen auf die gesamte Länge des überwachten Abschnitts 10 - den Ort an, an dem der Kurzschluss 17 zwischen der Phase 10c und Erde aufgetreten ist. Dafür wird die bekannte Maschenregel gemäß dem zweiten Kirchhoffschen Gesetz auf die in Figur 1 durch den Kurzschluss 17 zwischen der Messstelle A erzeugte Leiter-Erde-Schleife angewendet. Hieraus ergibt sich die folgende Maschengleichung:

$$-\underline{U}_A + \underline{I}_L \cdot m \cdot \underline{Z}_L + \underline{U}_F + \underline{I}_E \cdot m \cdot \underline{Z}_E = 0 \qquad\qquad (1)$$

Hierbei bedeuten die Formelzeichen (vergleiche auch Figur 1):

$\underline{U}_A$: den von dem Distanzschutzgerät 11 gemessenen Span- nungszeiger, der die Spannung zwischen der Phase 10c und Erde angibt;

$\underline{I}_L$: den von dem Distanzschutzgerät 11 gemessenen Strom- zeiger, der den in der Phase 10c fließenden Strom angibt;

m: die Entfernung von der Messstelle A zum Fehlerort des Kurzschlusses 17 bezogen auf die gesamte Länge des Abschnitts 10 (Fehlerortwert);

$\underline{Z}_L$: die Mitsystemimpedanz der Phase 10c;

$\underline{U}_F$: den Spannungsabfall am Fehlerort;

$\underline{I}_E$: den von dem Distanzschutzgerät 11 gemessenen Erd- stromzeiger, der den in der Erde fließenden Strom angibt; und

$\underline{Z}_E$: die Erdimpedanz.

Unter Verwendung dieser Gleichung (1) kann die Datenverarbeitungseinrichtung 15 des Distanzschutzgerätes 11 bei Kenntnis der Werte für die Leitungsimpedanz und die Erdimpedanz den Fehlerortwert m bestimmen, da die entsprechenden Strom-, Erdstrom- und Spannungsmesswerte durch Messung zum Zeitpunkt des Kurzschlusses bekannt sind. Der Wert des Spannungsabfalls $U_F$ an der Fehlerstelle kann üblicherweise bei einer einseitigen Fehlerortung nicht bestimmt werden. Er kann aber ohne zu großen Einfluss auf das Endergebnis vernachlässigt werden.

Obwohl in Gleichung (1) Messwerte von Strom, Erdstrom und Spannung als Zeiger dargestellt sind und folglich Informationen über Amplitude und Phasenlage umfassen, ist das beschriebene Verfahren auch mit skalaren Größen (Amplituden, rms-Werten, Effektivwerten) durchführbar.

Während die Leitungsimpedanz $Z_L$ der Phase 10c weitestgehend konstant und unabhängig von äußeren Einflüssen ist, verändert sich der Wert der Erdimpedanz $Z_E$ in Abhängigkeit von Umgebungsparametern, wie beispielsweise Temperatur und Feuchtigkeit. So besitzt beispielsweise ein mit Feuchtigkeit durchtränktes Erdreich eine geringere Impedanz als ein trockener Boden. Die Datenverarbeitungseinrichtung 15 des Distanzschutzgerätes 11 erfasst nun in unten näher beschriebener Weise den Wert zumindest eines Umgebungsparameters, der einen Einfluss auf die Erdimpedanz hat, wie beispielsweise Temperatur oder Feuchtigkeit des Erdreiches sowie Lufttemperatur oder Luftfeuchtigkeit, und berechnet in Abhängigkeit davon den für die Fehlerortung zu verwendenden Wert der Erdimpedanz. Dazu wird eine mathematische Funktion eingesetzt, die den Zusammenhang zwischen der Erdimpedanz einerseits und einem oder mehreren Umgebungsparameters andererseits beschreibt. Durch eine dynamische Berechnung der Erdimpedanz in Abhängigkeit von dem zumindest einen Umgebungsparameter kann der Ort des Erdfehlers mit größerer Genauigkeit bestimmt werden als bei einem statisch festgelegten Wert der Erdimpedanz.

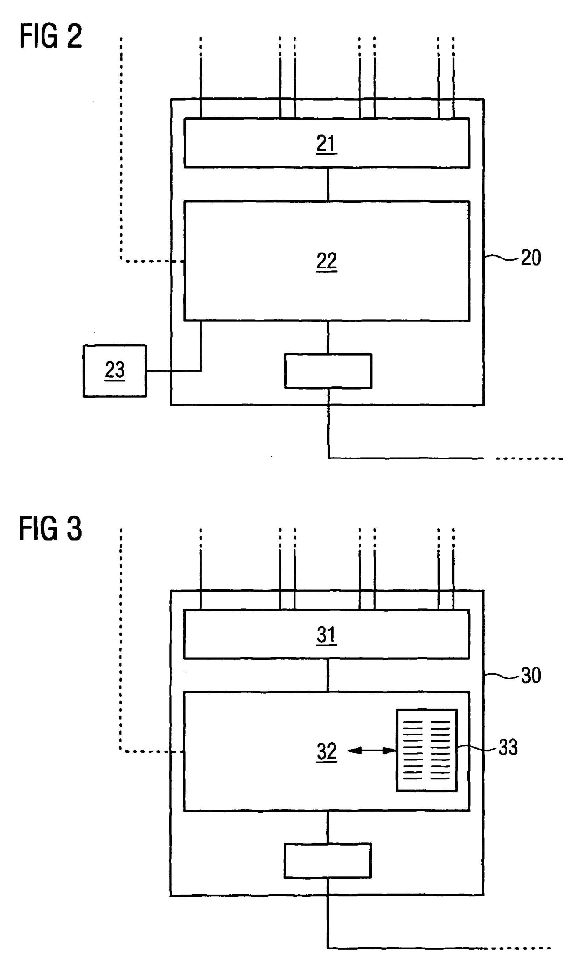

Anhand der Figuren 2 und 3 soll erläutert werden, wie die Werte der Umgebungsparameter dem Distanzschutzgerät 11 (Figur 1) zugeführt werden.

Figur 2 zeigt hierzu ein erstes Ausführungsbeispiel eines elektrischen Distanzschutzgerätes 20, das eine Messwerterfassungseinrichtung 21 und eine Datenverarbeitungseinrichtung 22 aufweist. Mit der Datenverarbeitungseinrichtung 22 ist eine Sensoreinrichtung 23 verbunden, die den Wert eines oder mehrerer Umgebungsparameter misst. Beispielsweise kann die Sensoreinrichtung Temperaturerfassungseinrichtungen für Luft- und/oder Bodentemperatur sowie Feuchtigkeitsmessgeräte für Luft- und/oder Bodenfeuchte aufweisen. Auf diese Weise kann der Wert zumindest eines Umgebungsparameters bestimmt werden. Der Wert des zumindest einen Umgebungsparameters wird der Datenverarbeitungseinrichtung 22 des Distanzschutzgerätes 20 zugeführt. Der zur Bildung des Fehlerortwertes m verwendete Wert der Erdimpedanz wird daraufhin in Abhängigkeit von dem Wert des zumindest einen Umgebungsparameters erzeugt. Hierzu ist in der Datenverarbeitungseinrichtung 22 eine mathematische Funktion hinterlegt, die die Abhängigkeit der Erdimpedanz von dem zumindest einen Umgebungsparameter beschreibt.

Figur 3 zeigt ein zweites Ausführungsbeispiel eines elektrischen Distanzschutzgerätes 30 mit einer Messwerterfassungseinrichtung 31 und einer Datenverarbeitungseinrichtung 32. Das zweite Ausführungsbeispiel unterscheidet sich von dem ersten dadurch, dass hierbei der Wert des zumindest einen Umgebungsparameters nicht explizit gemessen wird. Die Datenverarbeitungseinrichtung 32 umfasst nämlich eine Speichereinheit, in der in elektronische Form eine Tabelle 33 abgelegt ist, die typische Werte der Umgebungsparameter in Abhängigkeit der Jahres- und/oder Tageszeit angibt. Eine solche Tabelle kann beispielsweise aus klimabezogenen Messwerten für diejenige Region abgeleitet sein, in der der überwachte Abschnitt der elektrischen Energieübertragungsleitung verläuft. Die Datenverarbeitungseinrichtung benötigt in diesem Fall einen zusätzlichen Zeitgeber, der Tages- und/oder Jahreszeit angibt. Anhand dieser Zeitinformation kann die Datenverarbeitungseinrichtung 32 aus der elektronischen Tabelle 33 die benötigte Werte der Umgebungsparameter auslesen und zur Bildung der Erdimpedanz anhand der mathematischen Funktion verwenden.

Die mathematische Funktion zur Bildung der Erdimpedanz in Abhängigkeit von dem zumindest einen gemessenen oder aus der Tabelle ausgelesenen Umgebungsparameter kann beispielsweise bereits vorab (z.B. durch vorangegangene Messungen oder Simulationen) bekannt und in dem entsprechenden Distanzschutzgerät hinterlegt sein. Es ist jedoch auch möglich, dass das Distanzschutzgerät in einer sogenannten Lernphase sowohl den zumindest einen Umgebungsparameter durch Messung oder Auslesen aus einer Tabelle bestimmt als auch den zugehörigen Wert der Erdimpedanz durch explizite Messung bestimmt. Sind ausreichend viele zusammengehörige Werte der Erdimpedanz bei entsprechenden Werten des zumindest einen Umgebungsparameters aufgenommen worden, so berechnet das Distanzschutzgerät hieraus die benötigte mathematische Funktion und kann im Anschluss an die Lernphase unter Verwendung dieser mathematischen Funktion die Erdimpedanz bestimmen, ohne weitere explizite Messungen der Erdimpedanz durchführen zu müssen.

Eine messtechnische Bestimmung der Erdimpedanz kann beispielsweise gemäß dem Verfahren erfolgen, das in der internationalen Patentanmeldung PCT/DE2007/000870 der Anmelderin beschrieben ist. Hierbei wird durch eine zweiseitige Fehlerortung in Zusammenarbeit mit einem am anderen Ende des überwachten Leitungsabschnittes angeordneten weiteren Distanzschutzgerät auf den Wert der Erdimpedanz geschlossen.

Zur Kommunikation mit einem anderen Distanzschutzgerät weist das Distanzschutzgerät 11 (vgl. Figur 1) in diesem Zusammenhang eine Kommunikationseinrichtung 19 auf, mittels der Messdaten zwischen den Distanzschutzgeräten ausgetauscht werden können.

Eine solche Lernphase zur Bestimmung der mathematischen Funktion, die die Abhängigkeit der Erdimpedanz von dem zumindest einen Umgebungsparameter beschreibt, kann einmalig (z.B. während einer Inbetriebsetzung des Distanzschutzgerätes) stattfinden oder in bestimmten Zeitabständen wiederholt werden. Durch ein wiederholtes Durchführen der Lernphase kann eine bereits bestehende mathematische Funktion überprüft oder weiter verfeinert werden. Die Wiederholung einer solchen Lernphase kann regelmäßig stattfinden oder durch bestimmte Werte des zumindest einen Umgebungsparameters, wie beispielsweise eine extrem hohe Feuchtigkeit oder Trockenheit, angestoßen werden.

**Patentansprüche**

1.  Verfahren zum Orten eines Erdfehlers auf einem Abschnitt einer elektrischen Energieversorgungsleitung nach dem Distanzschutzprinzip, wobei beim Auftreten eines Erdfehlers auf dem Abschnitt

    - ein den in dem Abschnitt (10) fließenden Strom angebender Strommesswert erfasst wird;
    - ein die an dem Abschnitt (10) anliegende Spannung angebender Spannungsmesswert erfasst wird;
    - ein den entlang des Abschnitts (10) fließenden Erdstrom angebender Erdstrommesswert erfasst wird; und
    - mit den erfassten Messwerten ein Fehlerortwert berechnet wird, der den Ort des Erdfehlers auf dem Abschnitt (10) angibt, wobei dieser Fehlerortwert unter Verwendung der Leitungsimpedanz des Abschnitts (10) und der Erdimpedanz des entlang des Abschnitts (10) verlaufenden Erdreiches gebildet wird;

    **dadurch gekennzeichnet, dass**

    - der Wert der zur Bildung des Fehlerortwertes verwendeten Erdimpedanz in Abhängigkeit zumindest eines Umgebungsparameters, der Umwelteinflüsse auf das betroffene Erdreich beschreibt, dynamisch festgelegt wird.

2.  Verfahren nach Anspruch 1,
    **dadurch gekennzeichnet, dass**

    - als Umgebungsparameter zumindest ein Parameter aus folgender Auflistung verwendet wird: eine Luftfeuchtigkeit, eine Feuchtigkeit des betroffenen Erdreiches, eine Lufttemperatur, eine Temperatur des betroffenen Erdreiches.

3.  Verfahren nach Anspruch 1 oder 2,
    **dadurch gekennzeichnet, dass**

    - der zumindest eine verwendete Umgebungsparameter kontinuierlich gemessen wird.

4.  Verfahren nach Anspruch 1 oder 2,
    **dadurch gekennzeichnet, dass**

    - der zumindest eine verwendete Umgebungsparameter aus einer elektronischen Tabelle (33) in Abhängigkeit der aktuellen Jahres- und/oder Tageszeit ausgelesen wird.

5.  Verfahren nach einem der vorangehenden Ansprüche,
    **dadurch gekennzeichnet, dass**

    - während einer Lernphase der zu dem zumindest einen verwendeten Umgebungsparameter gehörende Wert der Erdimpedanz gemessen wird;
    - eine Abhängigkeit des Wertes der Erdimpedanz von dem zumindest einen verwendeten Umgebungsparameter in Form einer mathematischen Funktion bestimmt wird; und
    - im Anschluss an die Lernphase der Wert der Erdimpedanz unter Anwendung dieser mathematischen Funktion bestimmt wird.

6.  Verfahren nach Anspruch 5,
    **dadurch gekennzeichnet, dass**

    - die Lernphase und die Bestimmung der mathematischen Funktion wiederholt durchgeführt werden.

**7.** Verfahren nach einem der vorangehenden Ansprüche,
**dadurch gekennzeichnet, dass**

- bei einer mehrphasigen elektrischen Energieübertragungsleitung das Verfahren für jede Phase (10a,10b,10c) der Energieübertragungsleitung durchgeführt wird.

**8.** Elektrisches Distanzschutzgerät (11) zur Erfassung und Ortung von Erdfehlern auf einen Abschnitt (10) einer elektrischen Energieübertragungsleitung mit

- einer Messwerterfassungseinrichtung (14) zum Erfassen von Strom- und Spannungsmesswerten sowie Erdstrommesswerten, die Werte des in dem Abschnitt (10) fließenden Stromes und der an diesem anliegenden Spannung sowie des entlang des Abschnitts fließenden Erdstromes angeben; und
- einer Datenverarbeitungseinrichtung (15), die mit den erfassten Messwerten einen Fehlerortwert berechnet, der den Ort des Erdfehlers auf dem Abschnitt angibt, wobei dieser Fehlerortwert unter Verwendung der Leitungsimpedanz des Abschnitts (10) und der Erdimpedanz des entlang des Abschnitts (10) verlaufenden Erdreiches gebildet wird;

**dadurch gekennzeichnet, dass**

- die Datenverarbeitungseinrichtung (15) zur Durchführung eines Verfahrens gemäß einem der Ansprüche 1 bis 7 eingerichtet ist.

**Claims**

**1.** Method for locating an earth fault on a section of an electrical power supply line on the basis of the distance protection principle, wherein, in the event of the occurrence of an earth fault on the section,

- a current measurement value indicating the current flowing in the section (10) is detected;
- a voltage measurement value indicating the voltage present at the section (10) is detected;
- an earth current measurement value indicating the earth current flowing along the section (10) is detected; and
- the detected measurement values are used to calculate a fault location value, which indicates the location of the earth fault on the section (10), this fault location value being formed using the line impedance of the section (10) and the earth impedance of the area of ground running along the section (10);

**characterized in that**

- the value of the earth impedance used for forming the fault location value is established dynamically as a function of at least one environmental parameter which describes environmental influences on the area of ground in question.

**2.** Method according to Claim 1,
**characterized in that**

- at least one parameter from the following list is used as the environmental parameter: an air humidity, a humidity of the area of ground in question, an air temperature, a temperature of the area of ground in question.

**3.** Method according to Claim 1 or 2,
**characterized in that**

- the at least one environmental parameter used is measured continuously.

**4.** Method according to Claim 1 or 2,
**characterized in that**

- the at least one environmental parameter used is read from an electronic table (33) as a function of the current time of year and/or time of day.

**5.** Method according to one of the preceding claims,
**characterized in that**

- during a learning phase, the value of the earth impedance belonging to the at least one environmental parameter used is measured;
- a dependence of the value of the earth impedance on the at least one environmental parameter used is determined in the form of a mathematical function; and
- after the learning phase, the value of the earth impedance is determined using this mathematical function.

**6.** Method according to Claim 5,
**characterized in that**

- the learning phase and the determination of the mathematical function are performed repeatedly.

**7.** Method according to one of the preceding claims,
**characterized in that**

- in the case of a polyphase electrical power transmission line, the method is performed for each phase (10a, 10b, 10c) of the power transmission line.

**8.** Electrical distance protection device (11) for detecting and locating earth faults on a section (10) of an electrical power transmission line with

- a measurement value detection device (14) for detecting current and voltage measurement values and earth current measurement values which indicate values of the current flowing in the section (10) and of the voltage present at said section and of the earth current flowing along the section; and
- a data processing device (15), which uses the measurement values detected to calculate a fault location value, which indicates the location of the earth fault on the section, with this fault location value being formed using the line impedance of the section (10) and the earth impedance of the area of ground running along the section (10);

**characterized in that**

- the data processing device (15) is designed for implementing a method according to one of Claims 1 to 7.

**Revendications**

**1.** Procédé de localisation d'un défaut à la terre sur un tronçon d'une ligne électrique d'alimentation en électricité suivant le principe de protection de distance, dans lequel, lorsqu'il apparaît un défaut à la terre sur le tronçon

- on relève une valeur de mesure du courant indiquant le courant passant dans le tronçon ( 10 ) ;
- on relève une valeur de mesure de la tension indiquant la tension s'appliquant au tronçon ( 10 ) ;
- on relève une valeur de mesure du courant de terre indiquant le courant de terre passant le long du tronçon ( 10 ) ; et
- on calcule par les valeurs de mesure relevées une valeur de localisation du défaut, qui indique la localisation du défaut à la terre sur le tronçon ( 10 ), cette valeur de localisation du défaut étant formée en utilisant l'impédance de ligne du tronçon ( 10 et l'impédance de terre de la zone de terre s'étendant le long du tronçon ( 10 ) ;

**caractérisé en ce que**

- on fixe dynamiquement la valeur de l'impédance de terre utilisée pour la formation de la valeur de localisation du défaut en fonction d'au moins un paramètre d'environnement, qui décrit les influences de l'environnement sur le terrain concerné.

**2.** Procédé suivant la revendication 1,
**caractérisé en ce que**

- on utilise comme paramètre d'environnement au moins un paramètre de la liste suivante : une humidité de l'air, une humidité du terrain concerné, une température de l'air, une température du terrain concerné.

3. Procédé suivant la revendication 1 ou 2,
   **caractérisé en ce que**

   - on mesure en continu au moins un paramètre d'environnement utilisé.

4. Procédé suivant l'une des revendications 1 ou 2,
   **caractérisé en ce que**

   - on lit le au moins un paramètre d'environnement utilisé dans une table ( 33 ) électronique en fonction de la saison et/ou de l'heure du jour.

5. Procédé suivant l'une des revendications précédentes,
   **caractérisé en ce que**

   - pendant une phase d'apprentissage, on mesure la valeur de l'impédance de terre appartenant au au moins un paramètre d'environnement utilisé ;
   - on détermine sous la forme d'une fonction mathématique une dépendance de la valeur de l'impédance de terre au au moins un paramètre d'environnement utilisé ; et
   - à la suite de la phase d'apprentissage, on détermine la valeur de l'impédance de terre en utilisant cette fonction mathématique.

6. Procédé suivant la revendication 5,
   **caractérisé en ce que**

   - on effectue la phase d'apprentissage et la détermination de la fonction mathématique de manière répétée.

7. Procédé suivant l'une des revendications précédentes,
   **caractérisé en ce que**

   - pour une ligne électrique de transport d'électricité polyphasé, on effectue le procédé pour chaque phase ( 10a, 10b, 10c ) de la ligne de transport d'électricité.

8. Appareil ( 11 ) électrique de protection de distance pour relever et localiser des défauts à la terre sur un tronçon ( 10 ) d'une ligne électrique de transport d'électricité, comprenant

   - un dispositif ( 14 ) de relevé de valeurs de mesure, pour relever des valeurs de mesure de courant et de tension ainsi que des valeurs de mesure du courant de terre, qui indiquent les valeurs du courant passant dans le tronçon ( 10 ) et de la tension qui lui est appliquée ainsi que du courant de terre passant le long du tronçon ; et - un dispositif ( 15 ) informatique, qui calcule par les valeurs de mesure relevées une localisation de défaut, qui indique la localisation du défaut de terre sur le tronçon, cette valeur de localisation du défaut étant formée en utilisant l'impédance de ligne du tronçon ( 10 ) et l'impédance de terre du terrain s'étendant le long du tronçon ( 10 ) ;

   **caractérisé en ce que**

   - le dispositif ( 15 ) informatique est conçu pour effectuer un procédé suivant l'une des revendications 1 à 7.

# FIG 1

FIG 2

20

FIG 3

30

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1739441 A1
- DE 2007000870 W